# DEMANDE DE BREVET EUROPEEN

(11) **EP 4 851 864 A1**
(43) Date de publication de la demande: **09.12.2026**
(21) Numéro de dépôt: 26181120.2
(22) Date de dépôt: 26.05.2026
(51) Int. Cl.: G06N 3/065, B81B 5/00, H01G 5/16

(54) **NEURONE ARTIFICIEL**

(30) Priorité: 03.06.2025 FR 2505921
(71) Demandeur: Commissariat à l'Energie Atomique et aux Energies Alternatives, 75015 Paris (FR)
(72) Inventeur: PILLONNET, Gaël, 38054 GRENOBLE CEDEX 09 (FR); FANET, Hervé, 38054 GRENOBLE CEDEX 09 (FR); LEGRAND, Bernard, 31410 LAVERNOSE-LACASSE (FR); KARAMI, Armine, 75015 PARIS (FR)
(74) Mandataire: Cabinet Beaumont

(57) **Abrégé**

La présente description concerne un neurone artificiel comprenant un dispositif électromécanique à capacité variable comportant une partie fixe et au moins une première partie mobile, le dispositif électromécanique comportant :
- au moins des première (e₁) et deuxième (e₂) électrodes reliées à des bornes d'application de premier (x₁) et deuxième (x₂) signaux d'entrée du neurone ;
- une troisième électrode (m) montée sur la première partie mobile et reliée à une borne d'application d'un signal (GND) de référence ; et
- au moins une quatrième électrode (s₁) montée sur la partie fixe et reliée à une borne de fourniture d'un premier signal (V_{O}) de sortie du neurone,
dans lequel les première (e₁) et deuxième (e₂) électrodes présentent des surfaces différentes définissant des poids de pondération appliqués respectivement aux premier (x₁) et deuxième (x₂) signaux d'entrée.

## Description

### Domaine technique

La présente demande concerne le domaine des circuits électroniques comportant au moins un neurone artificiel, par exemple un réseau de plusieurs neurones artificiels. La présente demande vise en particulier des neurones artificiels à faible consommation électrique et/ou capables de fonctionner à haute température, ainsi que des systèmes électroniques comportant de tels neurones.

### Technique antérieure

De nombreux types de neurones artificiels, présentant un fonctionnement analogue à celui des neurones d'un cerveau humain et comportant chacun un circuit électronique comprenant par exemple une pluralité de transistors, ont été proposés. Les neurones artificiels sont généralement interconnectés de sorte à former un réseau permettant, selon l'application, de réaliser diverses fonctions - par exemple de traitement du signal, de contrôle, d'optimisation, de classification, etc. - à partir de signaux électriques reçus par les neurones faisant partie d'une couche d'entrée du réseau. Ces signaux électriques sont typiquement fournis par un capteur, par exemple un capteur comportant au moins un microsystème électromécanique (MEMS).

Les neurones artificiels existants souffrent toutefois de plusieurs inconvénients. En particulier, les neurones artificiels existants présentent une consommation électrique relativement importante et sont en outre incompatibles avec un fonctionnement à des températures élevées, par exemple de l'ordre de plusieurs centaines de degrés Celsius. Par ailleurs, les dispositifs intégrant les réseaux de neurones artificiels existants requièrent la mise en œuvre d'éléments électroniques actifs permettant de fournir les signaux électriques d'entrée et de reconditionner des signaux échangés entre des couches du réseau de neurones.

### Résumé de l'invention

Il existe un besoin d'améliorer les neurones artificiels existants, ainsi que les réseaux de neurones artificiels existants et les systèmes intégrant de tels réseaux de neurones. Il serait notamment souhaitable de réduire la consommation électrique et d'améliorer la résistance à la chaleur des neurones artificiels existants. Il serait en outre souhaitable de pouvoir disposer de systèmes à base de neurones artificiels dépourvus d'éléments électroniques actifs, ou comprenant un nombre réduit de tels éléments.

Pour cela, un mode de réalisation prévoit un neurone artificiel comprenant un dispositif électromécanique à capacité variable comportant une partie fixe et au moins une première partie mobile, le dispositif électromécanique comportant :
- au moins des première et deuxième électrodes reliées à des bornes d'application de premier et deuxième signaux d'entrée du neurone ;
- une troisième électrode montée sur la première partie mobile et reliée à une borne d'application d'un signal de référence ; et
- au moins une quatrième électrode montée sur la partie fixe et reliée à une borne de fourniture d'un premier signal de sortie du neurone,
dans lequel les première et deuxième électrodes présentent des surfaces différentes définissant des poids de pondération appliqués respectivement aux premier et deuxième signaux d'entrée.

Selon un mode de réalisation, les première, deuxième, troisième et quatrième électrodes sont en forme de peignes interdigités.

Selon un mode de réalisation, les peignes formés respectivement par les première et deuxième électrodes présentent des nombres de doigts différents.

Selon un mode de réalisation, les troisième et quatrième électrodes définissent une première capacité variable en fonction de la position de la première partie mobile par rapport à la partie fixe.

Selon un mode de réalisation, le neurone comprend en outre une borne d'application d'une tension d'alimentation variable périodique.

Selon un mode de réalisation, le neurone comprend en outre une cinquième électrode montée sur la partie fixe et reliée à la borne d'application de la tension d'alimentation variable périodique.

Selon un mode de réalisation, les quatrième et cinquième électrodes sont en forme de peignes interdigités.

Selon un mode de réalisation, le neurone comprend en outre une sixième électrode montée sur la partie fixe et reliée à une borne de fourniture d'un deuxième signal de sortie du neurone complémentaire du premier signal de sortie.

Selon un mode de réalisation, les troisième et sixième électrodes définissent une deuxième capacité variable en fonction de la position de la première partie mobile par rapport à la partie fixe.

Selon un mode de réalisation, les première et deuxième électrodes sont situées de part et d'autre d'une partie de la troisième électrode s'étendant latéralement le long d'une direction sensiblement orthogonale à la direction de déplacement de la partie mobile.

Un mode de réalisation prévoit un réseau de neurones comprenant au moins des premier et deuxième neurones tels que décrits précédemment, dans lequel la quatrième électrode du premier neurone est reliée à la première ou à la deuxième électrode du deuxième neurone.

Selon un mode de réalisation, le premier neurone comporte en outre au moins une deuxième partie mobile sur laquelle sont montées ses première et deuxième électrodes.

Selon un mode de réalisation, les première et deuxième électrodes du deuxième neurone sont montées sur la partie fixe du dispositif électromécanique du deuxième neurone.

Un mode de réalisation prévoit un système comprenant :
- un accéléromètre comportant au moins une masse d'épreuve ; et
- un réseau de neurones tel que décrit précédemment, les première et deuxième électrodes du premier neurone étant solidaires mécaniquement de ladite au moins une masse d'épreuve.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre, de façon schématique et partielle, un exemple de neurone artificiel selon un mode de réalisation ;
la figure 2 illustre, de façon schématique et partielle, le neurone artificiel de la figure 1 dans une autre position de fonctionnement ;
la figure 3 illustre une variante de réalisation du neurone artificiel de la figure 1 ;
la figure 4 est un schéma électrique équivalent du neurone artificiel de la figure 3 ;
la figure 5 est un chronogramme illustrant le fonctionnement du neurone artificiel de la figure 1 ;
la figure 6 illustre, de façon schématique et partielle, un réseau de neurones artificiels selon un mode de réalisation ; et
la figure 7 illustre, de façon schématique et partielle, une autre variante du neurone artificiel de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des dispositifs à capacité variable à commande électromécanique des neurones artificiels décrits n'a pas été détaillée. La réalisation de tels dispositifs est à la portée de la personne du métier à partir des indications de la présente description, par exemple en utilisant des procédés connus de réalisation de microsystèmes électromécaniques (MEMS).

Par ailleurs, les différentes applications des neurones artificiels de la présente description et les divers dispositifs susceptibles d'intégrer ces neurones artificiels n'ont pas été détaillés, les modes de réalisation décrits étant compatibles avec tous ou la plupart des applications et dispositifs usuels mettant en œuvre au moins un neurone artificiel, moyennant éventuellement des adaptations à la portée de la personne du métier à la lecture de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % ou à 10° près, de préférence à 5 % ou à 5° près.

Dans la présente description, on entend par plaque, poutre ou région conductrice une plaque, poutre ou région en un matériau apte à conduire des charges électriques, ce matériau pouvant être un matériau conducteur, par exemple un métal, ou encore un matériau semiconducteur, par exemple du silicium.

Sauf précision contraire, on entend par signal logique un signal ne pouvant prendre que deux états parmi :
- un état haut (1 logique), correspondant par exemple à un premier niveau de tension ; et
- un état bas (0 logique), correspondant à un deuxième niveau de tension strictement inférieur au premier niveau.

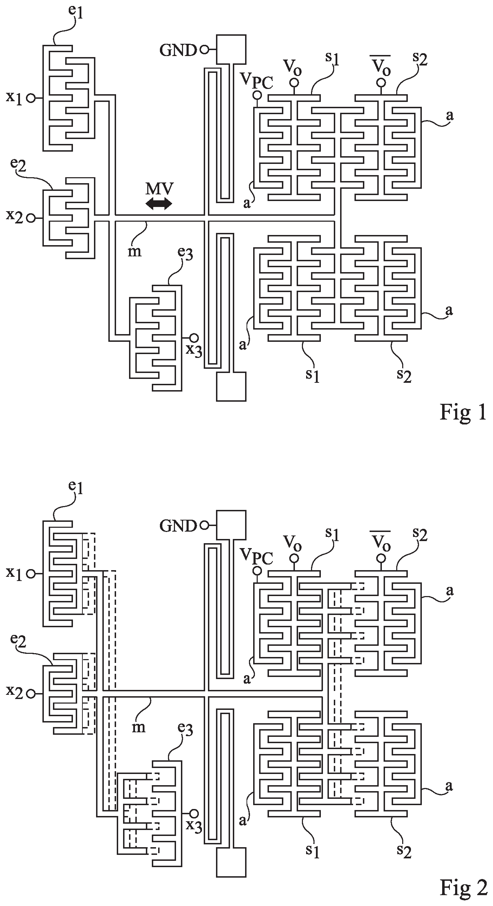

La figure 1 illustre, de façon schématique et partielle, un exemple de neurone artificiel selon un mode de réalisation.

Le neurone artificiel de la figure 1 est implémenté au moyen d'un unique dispositif micro-électromécanique à capacité variable comprenant sept électrodes. Plus particulièrement, dans l'exemple représenté, le neurone artificiel de la figure 1 comprend trois électrodes d'entrée e₁, e₂ et e₃, deux électrodes de sortie s₁ et s₂, une électrode intermédiaire m et une électrode d'alimentation a, isolées électriquement les unes des autres.

Le dispositif micro-électromécanique du neurone artificiel de la figure 1 comporte une partie fixe et une partie mobile (par rapport à la partie fixe). Les électrodes e₁, e₂, e₃, s₁, s₂ et a sont montées sur la partie fixe et l'électrode m est montée sur la partie mobile. Les électrodes m et e₁ définissent une capacité variable Cme₁. Les électrodes m et e₂ définissent une capacité variable Cme₂. Les électrodes m et e₃ définissent une capacité variable Cme₃. Les électrodes m et s₁ définissent une capacité variable Cms₁. Les électrodes m et s₂ définissent une capacité variable Cms₂.

Dans l'exemple illustré, les électrodes d'entrée e₁, e₂ et e₃ sont adaptées à recevoir des signaux d'entrée x₁, x₂ et x₃, respectivement. L'électrode mobile m est reliée, par exemple connectée, à un nœud GND d'application d'un potentiel de référence du dispositif, par exemple connecté à la masse. L'électrode a est reliée, par exemple connectée, à une borne d'application d'une tension d'alimentation variable V_{PC}, par exemple une tension alternative, du dispositif, référencée par rapport au nœud GND. Les électrodes de sortie s₁ et s₂ sont respectivement reliées, par exemple connectées, à des bornes de fourniture de tensions de sortie V_{O} et V̅_̅{̅O̅}̅, référencées par rapport au nœud GND. Les tensions de sortie V_{O} et V̅_̅{̅O̅}̅ sont par exemple plus particulièrement un signal binaire et son signal binaire logique complémentaire. Pour simplifier, les bornes d'application ou de fourniture des signaux sont, dans la présente description, désignées par les mêmes références que les signaux correspondants.

Dans l'exemple représenté, l'électrode m, d'une part, et les électrodes e₁, e₂ et e₃, d'autre part, sont en forme de peignes interdigités. Par ailleurs, dans cet exemple, l'électrode m, d'une part, et les électrodes s₁ et s₂, d'autre part, sont aussi en forme de peignes interdigités. Plus particulièrement, dans cet exemple, l'électrode m comprend plusieurs régions conductrices en forme de peignes, interdigitées respectivement avec des régions conductrices en peigne formant respectivement les électrodes e₁, e₂, e₃, s₁ et s₂. Les régions en peigne de l'électrode m sont reliées à une même poutre conductrice ou semiconductrice rigide. Dans l'exemple représenté, la poutre est fixée à la partie fixe du dispositif par l'intermédiaire de deux ressorts situés de part et d'autre de la poutre et permettant en outre de polariser la poutre au potentiel de référence GND. Chaque ressort comporte par exemple une poutre en forme de S disposé de sorte à permettre un déplacement de la poutre rigide de l'électrode m le long de l'axe horizontal et de sorte à empêcher tout déplacement de la poutre rigide de l'électrode m hors du plan de la figure 1.

Dans l'exemple illustré, les électrodes d'entrée e₁ et e₂ présentent des surfaces différentes. Plus particulièrement, dans cet exemple, le peigne formé par l'électrode e₁ présente un nombre de doigts supérieur au nombre de doigts du peigne formé par l'électrode e₂. De façon analogue, les électrodes e₂ et e₃ présentent, dans l'exemple illustré, des surfaces différentes (des nombres de doigts différents, dans l'exemple représenté où chaque électrode e₂, e₃ est en forme de peigne).

Dans l'orientation de la figure 1, les électrodes e₁ et e₂ sont situées à gauche d'une partie verticale de l'électrode m, orthogonale aux dents des peignes interdigités, tandis que l'électrode e₃ est située à droite de cette partie. Dans cet exemple, l'électrode e₃ exerce, sur l'électrode m, une force électrostatique opposée aux forces électrostatiques exercées, sur l'électrode m, par les électrodes e₁ et e₂.

Dans l'exemple illustré, lorsque le dispositif est en position de repos, c'est-à-dire lorsqu'aucune force n'est appliquée sur l'électrode m par les électrodes e₁, e₂ et e₃, les doigts des peignes interdigités ne présentent aucun recouvrement. Cela permet avantageusement au dispositif de présenter une consommation électrique réduite. À titre de variante, on pourrait prévoir un recouvrement entre les doigts des peignes interdigités lorsque le dispositif est dans la position de repos.

Dans l'exemple représenté, la structure mobile est adaptée à se déplacer selon une direction MV parallèle aux dents des peignes interdigités. Plus particulièrement, dans l'orientation de la figure 1, lorsque la somme des forces électrostatiques appliquées sur les électrodes e₁ et e₂ est strictement supérieure à la force électrostatique appliquée sur l'électrode e₃, l'électrode m se déplace vers la gauche. Il en résulte que la surface des dents de peigne de l'électrode s₁ en vis-à-vis de dents de peigne de l'électrode m augmente, tandis que la surface des dents de peigne de l'électrode s₂ en vis-à-vis de dents de peigne de l'électrode m diminue. Ainsi, la capacité Cms₁ (entre l'électrode m et l'électrode s₁) augmente et la capacité Cms₂ (entre l'électrode m et l'électrode s₂) diminue.

À l'inverse, lorsque la somme des forces électrostatiques appliquées sur les électrodes e₁ et e₂ est strictement inférieure à la force électrostatique appliquée sur l'électrode e₃, l'électrode m se déplace vers la droite, dans l'orientation de la figure 1. Il en résulte que la surface des dents de peigne de l'électrode s₁ en vis-à-vis de dents de peigne de l'électrode m diminue, tandis que la surface des dents de peigne de l'électrode s₂ en vis-à-vis de dents de peigne de l'électrode m augmente. Ainsi, la capacité Cms₁ (entre l'électrode m et l'électrode s₁) diminue et la capacité Cms₂ (entre l'électrode m et l'électrode s₂) augmente.

La position de l'électrode m est déterminée par l'équilibre des forces électrostatiques, le dispositif fonctionnant en régime quasi-statique.

La force électrostatique F_{e,i} appliquée sur chaque électrode eᵢ (avec i variant de 1 à 3, dans l'exemple représenté) du dispositif est proportionnelle au nombre de doigts de ladite électrode multiplié par le carré de la tension xᵢ appliquée sur ladite électrode. Ainsi, le nombre de doigts de chaque électrode eᵢ permet de moduler la contribution de la tension d'entrée appliquée sur ladite électrode. Dans l'exemple représenté, les nombres de doigts des électrodes e₁, e₂ et e₃ définissent des poids de pondération différents appliqués respectivement aux signaux d'entrée x₁, x₂ et x₃. De manière générale, plus la surface de l'électrode eᵢ est importante et plus la force électrostatique exercée par cette électrode sur l'électrode mobile m est grande. À titre de variante ou de complément, la force exercée sur l'électrode mobile m peut être modulée par le recouvrement des doigts lorsque le dispositif est en position de repos.

Le dispositif micro-électromécanique à capacité variable de la figure 1 peut être utilisé pour mettre en œuvre une fonction de neurone artificiel à trois entrées et à deux sorties complémentées. En figure 1, la partie mobile du dispositif est représentée dans la position de repos, ou position centrale, dans laquelle la somme des forces électrostatiques exercées par les électrodes e₁ et e₂ sur l'électrode m est sensiblement égale à la force électrostatique exercée par l'électrode e₃ sur l'électrode m. Cela correspond par exemple à un cas où les signaux d'entrée x₁, x₂ et x₃ respectivement appliqués sur les électrodes e₁, e₂ et e₃ sont sensiblement nuls.

La figure 2 illustre, de façon schématique et partielle, le neurone artificiel de la figure 1 dans une autre position de fonctionnement.

En figure 2, la partie mobile du dispositif est translatée vers la gauche par rapport à la position de fonctionnement illustrée en figure 1. Cela correspond par exemple à un cas où la somme des forces électrostatiques exercées par les électrodes e₁ et e₂ sur l'électrode m est strictement supérieure à la force électrostatique exercée par l'électrode e₃ sur l'électrode m. Dans ce cas, le signal de sortie V_{O} est par exemple à un état haut, le signal de sortie V̅_̅{̅O̅}̅ étant alors à un état bas. À l'inverse, dans le cas où la somme des forces électrostatiques exercées par les électrodes e₁ et e₂ sur l'électrode m est strictement inférieure à la force électrostatique exercée par l'électrode e₃ sur l'électrode m, le signal de sortie V_{O} est par exemple à un état bas et le signal de sortie V̅_̅{̅O̅}̅ est alors à un état haut.

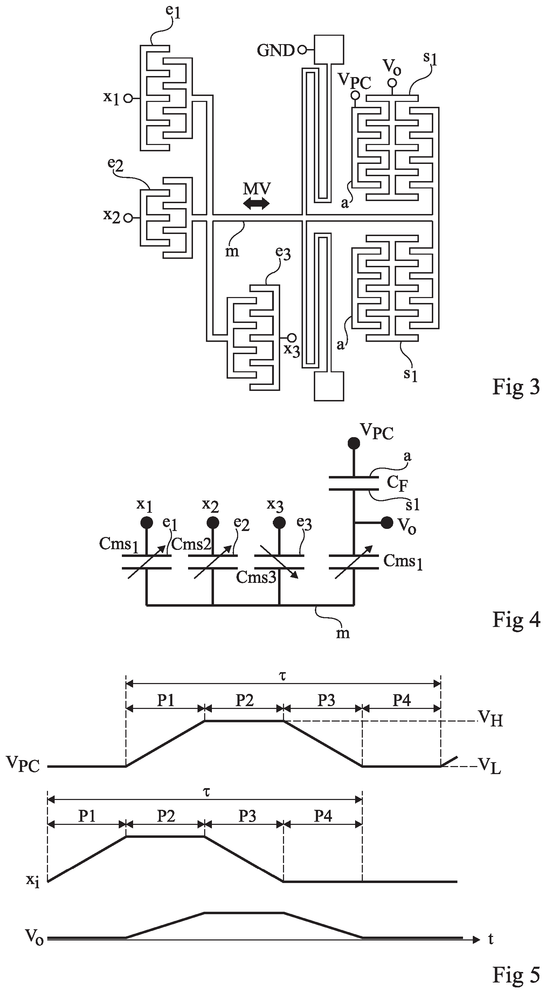

La figure 3 illustre une variante de réalisation du neurone artificiel de la figure 1. La variante de la figure 3 diffère de l'exemple de la figure 1 en ce que, dans cette variante, la partie fixe est dépourvue de l'électrode s₂ de sortie complémentaire et des peignes des électrodes m et a interdigités avec les peignes de l'électrode s₂.

La figure 4 est un schéma électrique équivalent du neurone artificiel de la figure 3.

Dans l'exemple représenté, les électrodes a et s₁ définissent une capacité fixe C_{F}. La tension V_{O} de sortie fournie sur l'électrode de sortie s₁ est modulée par un écart capacitif entre la capacité variable Cms₁ et la capacité fixe C_{F}. La tension de sortie V_{O} s'exprime comme suit :
[Math 1] ${V}_{O} = \frac{{C}_{F}}{{C}_{F} + {Cms}_{1} \left(\sum {\left({n}_{i}{x}_{i}\right)}^{2}\right)} {V}_{PC}$

Dans l'équation ci-dessus, nᵢ représente le nombre de doigts du peigne formé par l'électrode eᵢ (avec i variant de 1 à 3, dans l'exemple de la figure 3) et xᵢ représente la tension appliquée sur l'électrode eᵢ.

À titre d'exemple, l'état haut de chaque signal logique V_{O}, V̅_̅{̅O̅}̅ correspond à une tension strictement supérieure à une tension de mode commun V_{mc}, par exemple sensiblement égale à la valeur maximale de la tension d'alimentation V_{PC} divisée par deux. En pratique, la valeur de la tension de mode commun V_{mc} est par exemple réglée par la valeur de la capacité fixe C_{F} et par le rapport entre une capacité minimale Cₘᵢₙ et une capacité maximale Cₘₐₓ atteintes par la capacité variable correspondante.

La figure 5 est un chronogramme illustrant le fonctionnement du neurone artificiel de la figure 1. Plus particulièrement, la figure 5 illustre l'évolution, en fonction du temps t, de la tension d'alimentation V_{PC}, de la tension d'entrée xᵢ (par exemple la tension x₁) et de la tension de sortie V_{O}.

La tension d'alimentation V_{PC} est une tension variable périodique, fournie par une source de tension variable non représentée en figures 1 à 3. La tension V_{PC} varie de façon périodique et continue entre une valeur basse V_{L}, par exemple comprise entre 0 et 2 volts, et une valeur haute V_{H}, par exemple supérieure d'au moins 1 volt à la valeur V_{L}.

Dans l'exemple représenté, la tension d'alimentation V_{PC} est une tension trapézoïdale. Plus particulièrement, dans cet exemple, chaque période τ de la tension V_{PC} comprend quatre phases successives P1, P2, P3 et P4 sensiblement de même durée T=τ/4. Lors de la phase P1, la tension V_{PC} croît linéairement depuis sa valeur basse V_{L} jusqu'à sa valeur haute V_{H}. Lors de la phase P2, la tension V_{PC} reste sensiblement constante et égale à sa valeur haute V_{H}. Lors de la phase P3, la tension V_{PC} décroît linéairement depuis sa valeur haute V_{H} jusqu'à sa valeur basse V_{L}. Lors de la phase P4, la tension V_{PC} reste sensiblement constante et égale à sa valeur basse V_{L}.

En pratique, la tension d'alimentation trapézoïdale V_{PC} peut être approximée par une tension sinusoïdale de période τ.

Les tensions xᵢ et V_{O} sont synchronisées sur la tension d'alimentation V_{PC}, qui sert aussi de signal d'horloge. Les tensions xᵢ et V_{O} présentent une variation périodique de forme sensiblement identique à celle de la tension d'alimentation variable V_{PC}. En particulier, la tension xᵢ présente des phases P'1, P'2, P'3 et P'4 analogues respectivement aux phases P1, P2, P3 et P4 de la tension d'alimentation V_{PC}. Les tensions xᵢ et V_{O} définissent respectivement des signaux logiques INᵢ et OUT. Le signal logique INᵢ, respectivement OUT, est à un état haut lorsque l'amplitude de la tension variable périodique xᵢ, respectivement V_{O}, est à un niveau haut, par exemple proche de la valeur haute V_{H} de la tension d'alimentation V_{PC}, et est à un niveau bas lorsque l'amplitude de la tension variable périodique xᵢ, respectivement V_{O}, est à un niveau bas, par exemple proche de 0 volt. La tension xᵢ présente une avance de phase de l'ordre de T=τ/4 sur la tension d'alimentation V_{PC}. La tension V_{O} est quant à elle en phase avec la tension d'alimentation V_{PC}.

Dans l'exemple représenté, le signal d'entrée INᵢ est à l'état haut pendant une période τ, puis passe à l'état bas.

L'exemple illustré en figure 5 correspond au cas dans lequel la somme des forces électrostatiques exercées par les électrodes e₁ et e₂ sur l'électrode m est supérieure à la force électrostatique exercée par l'électrode e₃ sur l'électrode m. Dans ce cas, la capacité du condensateur Cms₁ augmente progressivement depuis une valeur basse Cms_{1,L} pendant la phase P'1 de croissance linéaire du signal xᵢ. À la fin de la phase P'1, la tension de sortie V_{O} du dispositif est sensiblement égale à la tension d'alimentation V_{PC} qui, à ce stade, est approximativement nulle (fin de la phase P4 de la tension V_{PC}). Lors de la phase P'1, l'électrode m subit un léger déplacement vers la gauche, dans l'orientation de la figure 1. Cela correspond par exemple à une étape de pré-actionnement, pendant laquelle la somme pondérée des entrées du neurone est évaluée.

Pendant la phase P'2 du signal xᵢ, la capacité du condensateur Cms₁ poursuit son augmentation jusqu'à atteindre une valeur haute Cms_{1,H}, et la tension de sortie V_{O} du dispositif suit sensiblement la croissance linéaire de la tension d'alimentation V_{PC} (phase P1 de la tension V_{PC}). Lors de la phase P'2, l'augmentation de la tension d'alimentation V_{PC} a pour effet d'accentuer le déplacement de l'électrode m (vers la gauche, dans cet exemple) débuté au cours de la phase P'1 précédente. En outre, lors de la phase P'2, les tensions V_{O} et V̅_̅{̅O̅}̅ de sortie du dispositif s'établissent progressivement ce qui amplifie encore davantage le déplacement de l'électrode m. Cela correspond par exemple à une étape d'activation du neurone.

La position de fonctionnement illustrée en figure 2 et précédemment décrite correspond par exemple à la fin de la phase P'2.

Pendant la phase P'3 de décroissance linéaire du signal xᵢ, la capacité du condensateur Cms₁ demeure sensiblement constante et égale à sa valeur haute Cms_{1,H} et la tension de sortie V_{O} du dispositif reste sensiblement égale à la tension d'alimentation V_{PC} qui, à ce stade, est égale à sa valeur haute V_{H} (phase P2 de la tension V_{PC}). Lors de la phase P'3, les tensions d'entrée diminuent mais cela ne modifie pas sensiblement la position de l'électrode m car les forces appliquées au niveau des électrodes de sortie s₁ et s₂ sont prédominantes. Cela permet de maintenir la position de l'électrode m par rapport aux électrodes s₁ et s₂, donc la valeur des capacités Cms₁ et Cms₂ en l'absence de signaux xᵢ appliqués sur les électrodes d'entrée eᵢ.

Pendant la phase P'4 du signal xᵢ, la capacité du condensateur Cms₁ décroît depuis sa valeur haute Cms_{1,H} jusqu'à sa valeur basse Cms_{1,L}, et la tension de sortie V_{O} du dispositif suit sensiblement la décroissance linéaire de la tension d'alimentation V_{PC} (phase P3 de la tension V_{PC}). La décroissance de la capacité du condensateur Cms₁ lors de la phase P'4 est due à la diminution progressive des forces électrostatiques exercées sur l'électrode m par les électrodes s₁ et s₂.

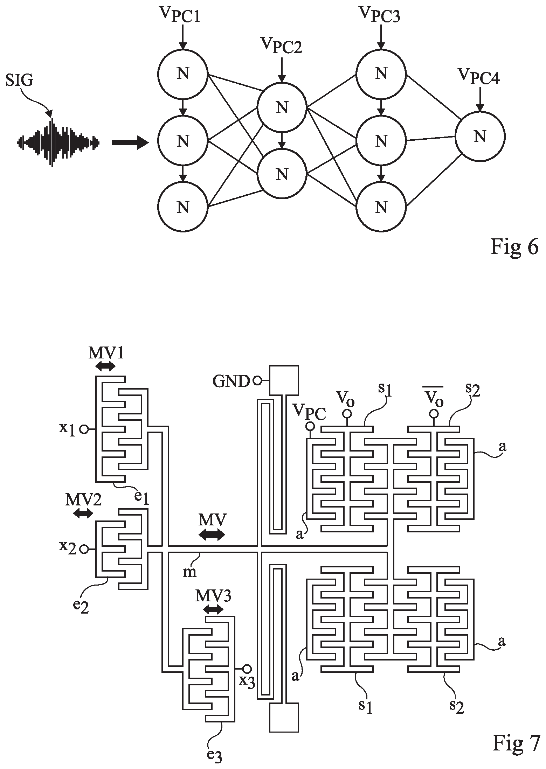

La figure 6 illustre, de façon schématique et partielle, un réseau de neurones artificiels selon un mode de réalisation.

Dans l'exemple représenté, le réseau comprend une pluralité de neurones artificiels N, par exemple identiques ou analogues aux neurones artificiels précédemment décrits en relation avec les figures 1 à 3. Les neurones N du réseau de la figure 6 sont organisés en couches. Plus particulièrement, dans l'exemple représenté, le réseau de neurones comprend, de gauche à droite, une couche d'entrée comportant trois neurones N, deux couches intermédiaires, ou couches cachées, comportant respectivement deux et trois neurones N, et une couche de sortie comportant un seul neurone N. En pratique, le réseau de neurones peut bien entendu comporter des nombres de neurones N et de couches différents de ceux représentés en figure 6, par exemple une centaine de neurones N répartis dans trois ou quatre couches.

Dans l'exemple décrit ci-dessus d'un fonctionnement à quatre phases, dans un réseau de neurones artificiels comportant plusieurs couches de neurones N, chaque neurone N reçoit, sur son électrode d'alimentation a, une tension variable périodique V_{PC} en retard de phase d'environ T=τ/4 sur la tension d'alimentation du neurone N de la couche précédente. Ceci permet que, dans chaque neurone N, chaque tension d'entrée xᵢ du neurone N soit en avance de phase d'environ T=τ/4 sur la tension d'alimentation V_{PC} du neurone N, comme exposé précédemment en relation avec la figure 5. Ainsi, dans un réseau de neurones comportant un nombre supérieur ou égal à 4 de couches de neurones N, on prévoira quatre tensions d'alimentation V_{PC1}, V_{PC2}, V_{PC3}, V_{PC4} similaires, c'est-à-dire de même fréquence, de même forme et de même niveau d'amplitude, mais déphasées deux à deux d'environ π/2.

Dans l'exemple illustré, des signaux électriques SIG sont transmis aux neurones N de la couche d'entrée du réseau. Les signaux électriques SIG sont par exemple issus d'au moins un capteur, par exemple un accéléromètre, relié au réseau de neurones. Chacune des tensions x₁, x₂ et x₃ précédemment décrites correspond par exemple, pour les neurones N de la couche d'entrée du réseau, à l'un des signaux électriques SIG et, pour les neurones N des couches intermédiaires et de la couche de sortie, à l'une des tensions de sortie V_{O} des neurones N de la couche précédente. À titre d'exemple, chaque électrode d'entrée e₁, e₂, e₃ de chaque neurone N des couches intermédiaires et de la couche de sortie est reliée, par exemple connectée, à l'une des électrodes de sortie s₁, s₂ de l'un des neurones N de la couche précédente.

La figure 7 illustre, de façon schématique et partielle, une autre variante du neurone artificiel de la figure 1. Le neurone de la figure 7 est par exemple utilisé pour réaliser les neurones N de la couche d'entrée du réseau de la figure 6, tandis que le neurone de la figure 1 ou de la figure 3 est par exemple utilisé pour réaliser les neurones N des autres couches du réseau.

Le neurone de la figure 7 diffère du neurone de la figure 1 principalement en ce que, dans le neurone de la figure 7, chaque électrode e₁, e₂, e₃ est montée sur une partie mobile du dispositif micro-électromécanique indépendante de la partie mobile sur laquelle est montée l'électrode m. Chaque électrode mobile e₁, e₂, e₃ du neurone de la figure 7 est par exemple solidaire mécaniquement d'une masse d'épreuve d'un accéléromètre, le déplacement de chaque masse d'épreuve provoquant un déplacement MV1, MV2, MV3 de l'électrode e₁, e₂, e₃ associée le long d'un axe horizontal, dans l'orientation de la figure 7. À titre d'exemple, les électrodes mobiles e₁, e₂ et e₃ sont respectivement fixées mécaniquement à trois masses d'épreuve indépendantes, par exemple des masses d'épreuve susceptibles de se déplacer respectivement selon trois directions orthogonales de l'espace. À titre de variante, les électrodes mobiles e₁, e₂ et e₃ peuvent être fixées mécaniquement à une même masse d'épreuve.

Dans le neurone de la figure 7, les tensions x₁, x₂ et x₃ appliquées sur les électrodes d'entrée e₁, e₂ et e₃ sont par exemple sensiblement constantes. À titre d'exemple, les nombres de doigts respectifs des peignes formés par les électrodes d'entrée e₁, e₂ et e₃ permettent de moduler l'influence de l'accélération dans les trois dimensions de l'espace.

Un avantage des neurones précédemment décrits en relation avec les figures 1 à 7 est qu'ils sont capables de résister à des températures élevées, par exemple de quelques centaines de degrés Celsius, et à une exposition à des rayonnements ionisants. Cela permet par exemple de réaliser des capteurs pour des applications de maintenance préventive, par exemple dans l'industrie nucléaire. Par ailleurs, les neurones de la présente description peuvent être mis en œuvre dans des systèmes réalisés entièrement à base de MEMS et dépourvus d'électronique d'interface.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la personne du métier est capable, à partir des indications de la présente description, d'omettre l'électrode de sortie complémentaire s₂ dans le neurone de la figure 7.

Par ailleurs, la personne du métier est capable de prévoir, à partir des indications de la présente description, des neurones artificiels comprenant des nombres d'électrodes d'entrée différents de ceux représentés, par exemple au moins deux électrodes d'entrée présentant des nombres de doigts différents et situées de part et d'autre d'une partie de l'électrode m s'étendant latéralement le long d'une direction sensiblement orthogonale à la direction de déplacement de la partie mobile. La personne du métier est en outre capable d'adapter la surface des électrodes, par exemple le nombre de doigts de chaque électrode, en fonction de l'application.

Par ailleurs, on notera que les modes de réalisation décrits sont compatibles avec des architectures utilisant des tensions d'alimentation variables périodiques dites rétractables, aussi appelées architecture à cadencement de Bennett (« Bennett clocking », en anglais), par exemple du type décrit en relation avec la figure 9 de la demande de brevet EP 3654534.

Enfin, la mise en œuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description.

Par ailleurs, la personne du métier est capable, à partir des indications de la présente description, de substituer tout ou partie des électrodes interdigitées par des électrodes planes présentant des surfaces différentes.

## Revendications

1. Neurone (N) artificiel comprenant un dispositif électromécanique à capacité variable comportant une partie fixe et au moins une première partie mobile, le dispositif électromécanique comportant :
- au moins des première (e₁) et deuxième (e₂) électrodes reliées à des bornes d'application de premier (x₁) et deuxième (x₂) signaux d'entrée du neurone (N) ;
- une troisième électrode (m) montée sur la première partie mobile et reliée à une borne d'application d'un signal (GND) de référence ; et
- au moins une quatrième électrode (s₁) montée sur la partie fixe et reliée à une borne de fourniture d'un premier signal (V_{O}) de sortie du neurone (N),
dans lequel les première (e₁) et deuxième (e₂) électrodes présentent des surfaces différentes définissant des poids de pondération appliqués respectivement aux premier (x₁) et deuxième (x₂) signaux d'entrée et dans lequel les première (e₁), deuxième (e₂), troisième (m) et quatrième (s₁) électrodes sont en forme de peignes interdigités comportant des dents parallèles à une direction de déplacement de la partie mobile.

2. Neurone (N) selon la revendication 1, dans lequel les peignes formés respectivement par les première (e₁) et deuxième (e₂) électrodes présentent des nombres de doigts différents.

3. Neurone (N) selon la revendication 1 ou 2, dans lequel les troisième (m) et quatrième (s₁) électrodes définissent une première capacité (Cms₁) variable en fonction de la position de la première partie mobile par rapport à la partie fixe.

4. Neurone (N) selon l'une quelconque des revendications 1 à 3, comprenant en outre une borne d'application d'une tension (V_{PC}) d'alimentation variable périodique.

5. Neurone (N) selon la revendication 4, comprenant en outre une cinquième électrode (a) montée sur la partie fixe et reliée à la borne d'application de la tension (V_{PC}) d'alimentation variable périodique.

6. Neurone (N) selon la revendication 5, dans lequel les quatrième (s₁) et cinquième (a) électrodes sont en forme de peignes interdigités.

7. Neurone (N) selon l'une quelconque des revendications 1 à 6, comprenant en outre une sixième électrode (s₂) montée sur la partie fixe et reliée à une borne de fourniture d'un deuxième signal (V̅_̅{̅O̅}̅) de sortie du neurone (N) complémentaire du premier signal (V_{O}) de sortie.

8. Neurone (N) selon la revendication 7, dans lequel les troisième (m) et sixième (s₂) électrodes définissent une deuxième capacité (Cms₂) variable en fonction de la position de la première partie mobile par rapport à la partie fixe.

9. Neurone selon l'une quelconque des revendications 1 à 8, dans lequel les première (e₁) et deuxième (e₂) électrodes sont situées de part et d'autre d'une partie de la troisième électrode (m) s'étendant latéralement le long d'une direction sensiblement orthogonale à la direction de déplacement de la partie mobile.

10. Réseau de neurones comprenant au moins des premier et deuxième neurones (N) selon l'une quelconque des revendications 1 à 9, dans lequel la quatrième électrode (s₁) du premier neurone (N) est reliée à la première (e₁) ou à la deuxième (e₂) électrode du deuxième neurone (N).

11. Réseau de neurones selon la revendication 10, dans lequel le premier neurone (N) comporte en outre au moins une deuxième partie mobile sur laquelle sont montées ses première (e₁) et deuxième (e₂) électrodes.

12. Réseau de neurones selon la revendication 10 ou 11, dans lequel les première (e₁) et deuxième (e₂) électrodes du deuxième neurone (N) sont montées sur la partie fixe du dispositif électromécanique du deuxième neurone (N).

13. Système comprenant :
- un accéléromètre comportant au moins une masse d'épreuve ; et
- un réseau de neurones selon l'une quelconque des revendications 10 à 12, les première (e₁) et deuxième (e₂) électrodes du premier neurone (N) étant solidaires mécaniquement de ladite au moins une masse d'épreuve.
